# EUROPÄISCHE PATENTSCHRIFT

(11) **EP 1 057 038 B1**
(45) Veröffentlichungstag und Bekanntmachung des Hinweises auf die Patenterteilung: **11.09.2002**
(21) Anmeldenummer: 99908871.9
(22) Anmeldetag: 10.02.1999
(51) Int. Cl.: G01R 31/28

(54) **VERFAHREN UND VORRICHTUNG ZUM PRÜFEN VON GEDRUCKTEN LEITERPLATTEN**
METHOD AND DEVICE FOR TESTING PRINTED CIRCUIT BOARDS
PROCEDE ET DISPOSITIF POUR LE TEST DE CARTES IMPRIMEES

(30) Priorität: 18.02.1998 DE 19806830; 12.05.1998 DE 19821225
(43) Veröffentlichungstag der Anmeldung: 06.12.2000
(73) Patentinhaber: Luther & Maelzer GmbH, D-31515 Wunstorf (DE)
(72) Erfinder: DE GRUYTER, Falko, D-31515 Wunstorf (DE); HIGGEN, Hans-Hermann, D-31655 Stadthagen (DE)
(74) Vertreter: Rupp, Christian, Dipl.-Phys.
(86) Internationale Anmeldenummer: EP9900873
(87) Internationale Veröffentlichungsnummer: WO99042850

(56) Entgegenhaltungen:
- DE-A- 4 009 296
- US-A- 5 032 789
- US-A- 5 412 313
- PATENT ABSTRACTS OF JAPAN vol. 096, no. 009, 30. September 1996 & JP 08 136614 A (FUJITSU LTD), 31. Mai 1996

## Beschreibung

Die Erfindung betrifft ein Verfahren zum Prüfen von gedruckten Leiterplatten, bei dem die Leiterplatten an bestimmten mit den Leiterbahnen verbundenen Kontaktpunkten mit leitenden Prüfkontakt-Elementen kontaktiert werden, bei dem die Prüfkontakt-Elemente oder eine Teilzahl von ihnen nach einem bestimmten Prüfprogramm taktmäßig nacheinander mit einer Prüfspannungsquelle verbunden werden, und bei dem während jedes Prüftaktes der über die Prüfkontakt-Elemente fließende Prüfstrom oder ein damit zusammenhängender Parameter gemessen wird.

Die Kontaktpunkte auf Leiterplatten dienen zum Ankontaktieren von elektronischen Bauelementen und sind in der Regel in einem bestimmten Raster angeordnet. Nach diesem Raster werden auch die Prüfkontakt-Elemente gesetzt. Letztere können durch Prüfstifte oder aber auch auf andere Weise realisiert werden, beispielsweise durch eine auf der Leiterplatte aufliegende elastische mit Graphitkugel-Einlagen versehene Gummischicht. Letztere wird an den Kontaktpunkten leitend, wenn sie an diesen Stellen zusammengedrückt wird.

Durch die Tendenz, elektronische Bauelemente immer kleiner zu machen und die Packungsdichte zu erhöhen, besteht an die Leiterplatten die Forderung, auch das Raster der Kontaktpunkte immer enger zu setzen. Die für den Einsatz in elektrischen Geräten bestimmten Leiterplatten werden dadurch in der Regel in ihren Abmessungen zwar kleiner; diese Verkleinerung wird jedoch bei der Fertigung in der Weise ausgenutzt, daß mehrere Grund-Muster, sogenannte Nutzen, auf einer Ausgangs-Leiterplatte vorgesehen werden. Die Ausgangs-Leiterplatte wird als Einheit getestet und erst später vereinzelt.

Die immer höher werdende Dichte von Kontaktpunkten auf zu prüfenden Leiterplatten hat zur Folge, daß auch die Zahl der bei der Prüfung durchzuführenden Messungen entsprechend größer wird.

Bisher hat man große Anstrengungen unternommen, um die mechanische Zeit für den Wechsel von zu prüfenden Leiterplatten immer stärker zu verkürzen. Der konstruktive Aufwand zur Realisierung kurzer Wechselzeiten ist inzwischen beträchtlich. Unter diesem Aspekt ist es unbefriedigend, wenn sich das Verhältnis der Meßzeit zur Wechselzeit immer mehr vergrößert, so daß die sich aus der Summe beider Zeiten ergebende Zykluszeit letztendlich in wesentlichen durch die Meßzeit bestimmt wird und der technische Aufwand zur Verkurzung der Wechselzeit nicht mehr gerechtfertigt erscheint.

Ein Verfahren nach dem Oberbegriff des Anspruchs 1 und eine Vorrichtung nach dem Oberbegriff des Anspruchs 2 sind in der US-A-5 032 789 beschrieben. Aus dieser Druckschrift ist eine Prüfvorrichtung für Bauteile oder Schaltkreise von Leiterplatten zu entnehmen. Die Prüfvorrichtung weist einen Testkopf mit mehreren Modulen auf, die jeweils eigene Ressourcen und einen eigenen, unabhängigen Prozessor aufweisen. Es können mehrere Module zum parallelen Prüfen von Teilbereichen einer Leiterplatte zusammengeschaltet werden. Hierbei wird dann, wenn die Ressourcen eines Moduls zum Testen der Leiterplatte nicht ausreichen, die Leiterplatte in parallel zu testende Prüfbereiche aufgeteilt.

DE 40 09 296 A offenbart eine Testvorrichtung zum Testen von mehreren Leiterplatten, die in einer speziellen Ausführung auch beim Ausfall eines Testkopfes durch das Vorhandensein mehrerer Testköpfe und einer entsprechenden Umschalteinheit weiter getestet werden können.

US-A-5 412 313 betrifft nicht die Prüfung einer gedruckten Leiterplatte sondern die Prüfung von elektronischen Bausteinen auf einer Leiterplatte.

Der Erfindung liegt die Aufgabe zugrunde, bei einem Verfahren nach dem Oberbegriff des Anspruchs 1 oder bei einer Vorrichtung nach dem Oberbegriff des Anspruchs 2 die Messzeit beim Testen von gedruckten Leiterplatten mit mehreren Grundmustern bzw. Nutzen zu verkürzen.

Diese Aufgabe wird durch die Merkmale des Anspruchs 1 oder 2 gelöst.

Beim erfindungsgemäßen Verfahren nach Anspruch 1 sind gleiche Grundmuster bzw. Nutzen der Leiterplatte vorgesehen, wobei die Grundmuster oder mindestens ein Teil von ihnen parallel geprüft werden bzw. wird.

Bei der erfindungsgemäßen Vorrichtung nach Anspruch 2 sind zumindest die Auswertemittel zur Durchführung einer Parallelprüfung von Grundmustern oder eines Teiles von ihnen in mehrfacher Zahl vorgesehen.

Ausgehend von dem eingangs beschriebenen Verfahren besteht die Lösung darin, dass die Leiterplatten in einer Mehrzahl von Prüfbereichen unterteilt werden, von denen jeder nur eine Teilzahl von Kontaktpunkten enthält, und dass alle oder mindestens ein Teil der Prüfbereiche parallel geprüft werden bzw, wird.

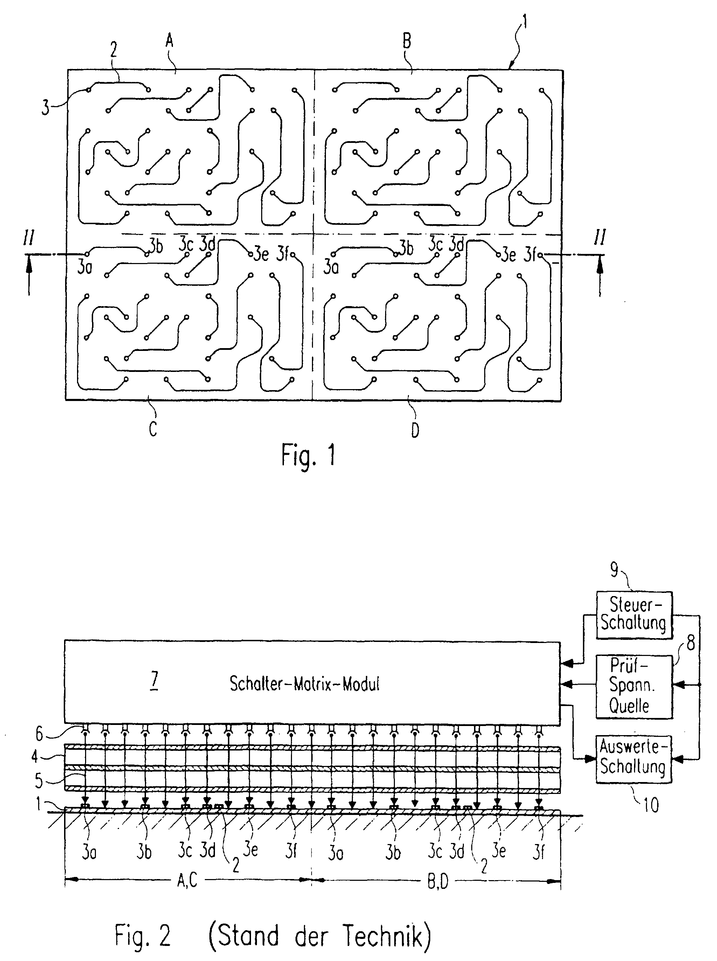

Sofern die Ausgangs-Leiterplatte im Mehrfachnutzen konzipiert worden ist, macht es Sinn, eine Zahl der Nutzen gleiche Zahl von Prüfbereichen vorzusehen, wobei jeder Prüfbereich die Leiterbahnen eines Nutzens enthält. Ein Beispiel dafür ist in Fig. 1 gezeigt. Vorteilhaft hierbei ist, dass die Messzeit für alle Nutzen gleich lang ist. Die Prüfung jedes Prüfbereiches kann beispielsweise so erfolgen, das nacheinander taktweise die eine Leiterbahn begrenzenden Kontaktpunkte mit der Prüfspannungquelle verbunden werden und durch Messung des Stromflusses festgestellt wird, ob die Leiterbahnen möglicherweise einen Unterbrechungsfehler aufweisen. Danach können taktweise nacheinander jeweils ein Kontaktpunkt einerseits und alle übrigen nicht mit diesem Kontaktpunkt durch eine Leiterbahn verbundenen Kontaktpunkte andererseits mit der Prüfspannungsquelle verbunden werden, um festzustellen, ob die mit dem Kontaktpunkt verbundene Leiterbahn möglicherweise einen unerwünschten Kontakt mit anderen Leiterbahnen hat und insofern einen Isolationsfehler aufweist. Alternativ dazu ist es auch möglich, bei der Parallelprüfung einen Nutzen zuerst auf Unterbrechungsfehler zu prüfen und bei der Prüfung eines anderen Nutzens mit der Isolationsfehler-Prüfung zu beginnen.

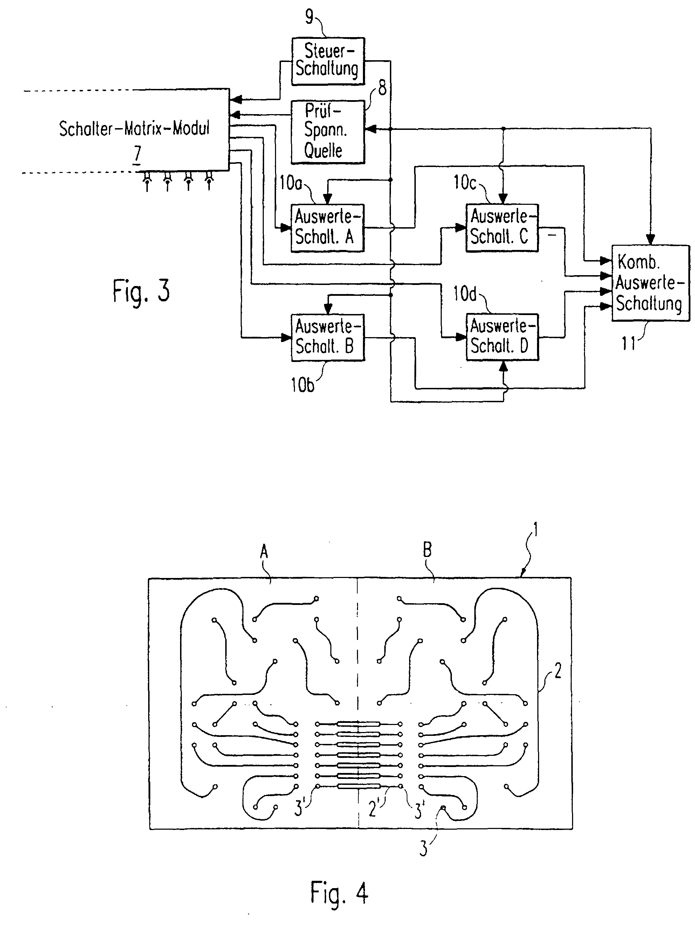

Es ist keinesfalls erforderlich, dass die Prüfbereiche so gelegt werden, dass sie nur Leiterbahnen enthalten, welche innerhalb dieser Prüfbereiche verlaufen. Stattdessen können die Prüfbereichs-Grenzen auch so gelegt werden, dass sie quer durch Leiterbahnen hindurchlaufen, so dass die Leiterbahnen gewissermaßen bereichsübergreifend sind. Dies ist insbesondere dann sinnvoll, wenn die Nutzengrenze ebenso verläuft und die bereichsübergreifenden Leiterbahnen nach Trennung der Ausgangs-Leiterplatte in Einzelnutzen ebenfalls getrennt werden. Ein Beispiel hierfür ist in Fig. 4 gezeigt. Hier ist aber darauf zu achten, dass bei der Parallelprüfung die bereichsübergreifenden Leiterbahnen nicht gleichzeitig von beiden Seiten mit Prüfspannung beaufschlagt werden. Dies kann durch ein entsprechendes Design des Prüfprogramms (Algorithmus) gewährleistet werden. Normalerweise kann man auch darauf verzichten, solche bereichsübergreifenden Leiterbahnen auf Unterbrechungsfehler zu überprüfen, da die Leiterbahnen - wie erwähnt - ohnehin getrennt werden.

Die erfindungsgemäße Lehre ist keinesfalls daran gebunden, die Bereichsgrenzen immer in Übereinstimmung mit den Nutzengrenzen zu legen. Sie ist vielmehr in aller Allgemeinheit zu verstehen und kann auch dann Anwendung finden, wenn eine zu prüfende Leiterplatte lediglich eine hohe Kontaktpunkt-Dichte hat, ohne daß sich ein Grundmuster in Form von Nutzen mehrfach wiederholt.

Die Erfindung betrifft ferner eine Vorrichtung zur Durchführung des vorstehend beschriebenen Verfahrens. Die Vorrichtung muß in bekannter Weise eine Vielzahl von zur Kontaktierung der Kontaktpunkte der Leiterbahnen bestimmten Prüfkontakt-Elementen enthalten, ferner eine Prüfspannungsquelle, Programmsteuermittel, variable Verbindungsmittel, welche von den Programmsteuermitteln so umschaltbar sind, daß die Prüfkontakt-Elemente einzeln oder in Gruppen nach einem bestimmten Prüfprogramm taktweise nacheinander mit der Prüfspannungsquelle verbunden werden, und Auswertemittel, welche den Stromfluß durch die Prüfkontakt-Elemente oder einen damit zusammenhängenden Parameter messen und auswerten.

Um Parallelmessungen der einzelnen Prüfbereiche realisieren zu können, muß erfindungsgemäß zumindest ein Teil der vorstehend beschriebenen Hardware entsprechend der Zahl der Prüfbereiche vervielfacht werden. Praktisch bedeutet das, daß zumindest die Auswertemittel zur Durchführung einer Parallelprüfung von Prüfbereichen in mehrfacher Zahl vorgesehen sein müssen.

Insgesamt ist zur Parallelprüfung zu bemerken, daß die zwei folgenden Bedingungen erfüllt sein müssen:
1. Die Prüfungen müssen unabhängig voneinander erfolgen, und es darf ein Prüfvorgang nicht auf das Ergebnis des anderen Prüfvorganges warten müssen. Mit it anderen Worten bedeutet das, daß das Meßergebnis eines Prüfbereiches nicht Grundlage für die Messung in einem anderen Prüfbereich sein darf.
2. Für die Parallelprüfung dürfen nicht die gleichen Ressourcen verwendet werden. Praktisch bedeutet daß, daß die für die Messung bzw. Auswertung erforderliche Hardware in mehrfacher Ausführung zur Verfügung stehen muß.

Zur Durchführung des erfindungsgemäßen Verfahrens besteht ebenso die Möglichkeit, die einzelnen Prüfbereiche durch Prüfmoduln zu realisieren, die in bekannter Weise nebeneinander angeordnet werden, wie dies beispielsweise in der EP-B1 0 108 405 beschrieben ist. Ansatzpunkt für den Stand der Technik nach dieser Patentschrift ist, daß der Besitzer einer Prüfvorrichtung sein Prüffeld durch Zukauf von Moduln beliebig erweitern kann. Es ist in dieser Druckschrift nicht daran gedacht, die Moduln autonom parallel arbeiten zu lassen. Sie sollen vielmehr wie ein einziger großer Modul zusammenwirken, derart, daß es möglich ist, auch bei sehr großen Leiterplatten eine Prüfung zwischen sehr entfernten Prüfpunkten vornehmen zu können.

Ausgehend von dem vorstehend beschriebenen Stand der Technik ist also eine Vorrichtung zum Prüfen von gedruckten Leiterplatten mit mehreren nebeneinander angeordneten Prüfmoduln bekannt, von denen jeder mit einer Vielzahl von leitenden Prüfkontakt-Elementen verbunden ist, die mit Kontaktpunkten auf den Leiterplatten nach einem bestimmten Prüfprogramm in Verbindung bringbar sind.

Wendet man die vorstehend erläuterte Erfindungsidee der Parallelprüfung darauf an, so ergibt sich die Lehre, das Prüfprogramm so auszulegen, daß die Prüfmoduln die ihnen räumlich zugeordneten Prüfbereiche der Leiterplatten gleichzeitig und unabhängig voneinander prüfen.

Ausführungsbeispiele der Erfindung werden nachfolgend anhand der Zeichnungen beschrieben. Darin zeigen:
- Fig. 1: die Draufsicht auf eine zu prüfende Ausgangs-Leiterplatte mit vier Nutzen;
- Fig. 2: einen Schnitt II-II durch die Ausgangs-Leiterplatte mit einer schematisch dargestellten bekannten Prüfvorrichtung, mittels welcher die Leiterplatte in herkömmlicher Weise geprüft werden kann;
- Fig. 3: einen Teil der Prüfvorrichtung aus Fig. 2 mit erfindungsgemäß geänderten Schaltungsteilen, so daß das erfindungsgemäße Prüfverfahren realisiert werden kann;
- Fig. 4: die Draufsicht auf eine weitere zu prüfende Ausgangs-Leiterplatte mit zwei Nutzen, aber bereichsübergreifenden Leiterbahnen;
- Fig. 5: einen Teil der Prüfvorrichtung aus Fig. 2, welcher zur Prüfung einer Ausgangsleiterplatte nach Fig. 4 geeignet ist und welcher außerdem alternativ zu Fig. 3 in erfindungsgemäßer Weise gestaltet ist;
- Fig. 6: ein aus mehreren autonomen Prüfmoduln zusammengesetztes Prüffeld in schematischer Darstellung; und
- Fig. 7 bis 13: verschiedene Anwendungsbeispiele für das aus mehreren Prüfmoduln zusammengesetzte Prüffeld von Fig. 6 in schematischer Darstellung.

Fig. 1 zeigt eine zu prüfende Ausgangs-Leiterplatte 1, die aus vier Nutzen A, B, C und D besteht. Jeder Nutzen ist mit dem gleichen Muster von Leiterbahnen 2 und Kontaktpunkten 3 versehen, wobei die Kontaktpunkte hier im Raster angeordnet sind. Die Kontaktpunkte 3 dienen zum Ankontaktieren von (nicht dargestellten) elektronischen Bauelementen.

Fig. 2 zeigt die Leiterplatte 1 im Schnitt II-II. Von diesem Schnitt werden die Kontaktpunkte 3a, 3b, 3c, 3d, 3e und 3f der beiden Nutzen C und D erfaßt. Die Leiterplatte 1 befindet sich hier in einer Prüfvorrichtung. die - da sie als solche bekannt ist - nur schematisiert gezeichnet ist.

Zu der Prüfvorrichtung gehört ein Adapter 4, der über der Leiterplatte 1 angeordnet ist, und beispielsweise aus drei mit Abstand zueinander angeordneten Platten besteht, die mit Durchführungslöchern für Prüfstifte 5 versehen sind. Die Prüfstifte 5 bestehen aus Metall. Sie weisen an ihrer der Leiterplatte 1 zugewandten Seite eine Prüfspitze auf und konktaktieren an ihrem der Leiterplatte 1 abgewandten Ende mit entsprechenden Gegenkontakten 6 eines Schalter-Matrix-Moduls 7. Die Gegenkontakte 6 des Schalter-Matrix-Moduls 7 sind im Raster angeordnet.

Die Kontaktpunkte 3 der Leiterplatte 1 sind im vorliegenden Fall im Raster angeordnet; sie können aber auch vom Raster abweichen. Ferner ist es auch nicht zwingend erforderlich, daß die Gegenkontakte 6 des Schalter-Matrix-Moduls 7 im Raster angeordnet sind. Der Adapter 4 hat die Aufgabe, eine Kontaktierung zu den Kontaktpunkten 3 auch dann zu gewährleisten, wenn die Kontaktpunkte 3 und/oder die Gegenkontakte 6 außer Raster liegen. In diesem Fall verlaufen die Prüfstifte 5 in den drei Platten des Adapters 4 entsprechend schräg.

Der Schalter-Matrix-Modul 7 ist mit einer Prüfspannungsquelle 8 sowie einer Steuerschaltung 9 verbunden. Die Steuerschaltung 9 steuert den Schalter-Matrix-Modul 7 mit einem bestimmten Prüftakt so, daß folgeweise abwechselnd bestimmte Prüfstifte mit der Prüfspannungsquelle 8 verbunden werden. Die Prüfspannungsquelle 8 wird ihrerseits von der Steuerschaltung getaktet, derart, daß sie nur während eines Taktes eine Prüfspannung abgibt und diese zwischen den Takten abschaltet. Aus der vorstehenden Beschreibung ergibt sich, daß der Schalter-Matrix-Modul 7 die hardwaremäßige Realisierung von - allgemein ausgedrückt - variablen Verbindungsmitteln ist, während die Steuerschaltung 9 als hardwaremäßige Realisierung von - allgemein beschrieben - Programmsteuermitteln anzusehen ist, wobei die Verbindungsmittel von den Programmsteuermitteln nach einem bestimmten Prüfprogramm taktweise so umschaltbar sind, daß die Prüfkontakt-Elemente - hier die Prüfstifte 5 - einzeln oder in Gruppen mit der Prüfspannungsquelle 8 verbunden werden können.

Mit einer ebenfalls mit dem Schalter-Matrix-Modul 7 verbundenen Auswerteschaltung 10 wird dann gemessen, ob in den einzelnen Takten ein Prüfstrom fließt oder nicht. Es versteht sich, daß statt des Prüfstromes auch ein anderer damit zusammenhängender elektrischer Parameter gemessen werden kann.

Die Steuerschaltung 9 arbeitet nach einem bestimmten ihr inhärenten Prüfprogramm (Algorithmus), mittels welchem festgestellt werden kann, ob Leiterbahnen unterbrochen sind (Unterbrechungsfehler) oder ob ein Kurzschluß zu anderen Leiterbahnen vorliegt (Isolationsfehler).

Zur Feststellung eines Unterbrechungsfehlers werden nacheinander jeweils zwei Prüfstifte 5 mit der Prüfspannung der Prüfspannungsquelle 8 beaufschlagt, wobei die jeweils zwei Prüfstifte 5 so ausgewählt sind, daß sich zwischen den von ihnen kontaktierten Kontaktpunkten 3 die zu prüfende Leiterbahn 2 erstreckt. Das von der Auswerteschaltung 10 ermittelte Prüfergebnis (Stromfluß vorhanden oder nicht) kann beispielsweise mit den vorgegebenen Daten einer Master-Platte verglichen werden. Bei Abweichungen von den vorgegebenen Daten der Master-Platte liegt ein Unterbrechungsfehler vor, dessen Position - wenn es gewünscht ist - eingegrenzt werden kann, da die Positionen der Kontaktpunkte der betreffenden Leiterbahn bekannt sind.

Zur Feststellung eines Isolations-Fehlers werden nacheinander die Prüfstifte 5, die mit den Kontaktpunkten 3 einer Leiterbahn 2 in Verbindung stehen - einerseits - und die Prüfstifte 5, die mit den übrigen Kontaktpunkten 3 in Verbindung stehen - andererseits - mit der Prüfspannung der Prüfspannungsquelle 8 beaufschlagt. Das von der Auswerteschaltung 10 ermittelte Prüfergebnis wird wiederum mit den Daten der Masterplatte verglichen. Bei Abweichung liegt ein Isolationsfehler vor. Auch hier kann wieder - wenn es gewünscht ist - eine Eingrenzung des Fehlers vorgenommen werden.

Wesentlich an dem in Verbindung mit Fig. 2 beschriebenen bekannten Prüfverfahren ist, daß die Kontaktpunkte der Ausgangs-Leiterplatte 1 nacheinander abgearbeitet werden. Das bedeutet beispielsweise, daß die sich zwischen den Kontaktpunkten 3a und 3b erstreckende Leiterbahn 2 des Nutzens C in der vorstehend beschriebenen Weise auf Unterbrechung geprüft wird und daß danach die gleiche Prüfung nochmals für die Leiterbahn 2 vorgenommen wird, die sich zwischen den Kontaktpunkten 3a und 3b des Nutzens D erstreckt. Insgesamt wird bei Zugrundelegung der Ausgangs-Leiterplatte 1 in Fig. 1 die Prüfung der sich zwischen den Prüfpunkten 3a und 3b erstreckenden Leiterbahn 2 nach dem Stand der Technik viermal nacheinander vorgenommen.

Nach dem erfindungsgemäßen Verfahren ist nun vorgesehen, daß die Prüfung der vier Nutzen A, B, C und D auf Unterbrechung der Leiterbahnen und/oder Isolation einer Leiterbahn gegen andere parallel, d.h. gleichzeitig erfolgt. Es liegt auf der Hand, daß die Prüfzeit in diesem Fall nur ein Viertel derjenigen Prüfzeit beträgt, die für eine Prüfung in der herkömmlichen Weise erforderlich ist.

Fig. 3 zeigt schematisch, wie das erfindungsgemäße Verfahren hardwaremäßig realisiert werden kann. Da die Teile 1-7 aus Fig. 2 auch bei der erfindungsgemäß gestalteten Prüfvorrichtung in unveränderter Form vorhanden sind, sind in Fig. 3 nur ein Teil des unveränderten Schalter-Matrix-Moduls 7 und ansonsten die neuen die Erfindung realisierenden Schaltungsteile dargestellt. Es sind dies vier Auswerteschaltungen 10a, 10b, 10c und 10d, von denen jede mit dem Schalter-Matrix-Modul 7 verbunden ist. Mit diesen vier Auswerteschaltungen erfolgt die Auswertung der Prüfung der vier Nutzen A, B, C und D separat. Die Steuerschaltung 9 erzeugt wiederum einen Prüftakt und taktet die Prüfspannungsquelle 8 sowie die vier Auswerteschaltungen 10a-10d, Außerdem steuert die Steuerschaltung 9 den Schalter-Matrix-Modul 7 nach einem geänderten Prüfprogramm, und zwar in der Weise, daß beispielsweise die mit den Prüfkontakten 3a und 3b der vier Nutzen A, B, C und D in Kontakt stehenden Prüfstifte (insgesamt acht) gleichzeitig mit der von der Prüfspannungsquelle 8 erzeugten Prüfspannung beaufschlagt werden, so daß durch die vier Leiterbahnen 2 ein Strom fließen muß. Dieser Stromfluß wird separat und parallel von den vier Auswerteschaltungen 10a-10d gemessen. Mißt eine Auswerteschaltung keinen Strom, so ist die betreffende Leiterbahn 2 unterbrochen.

Das Prüfergebnis der vier Auswerteschaltungen 10a-10d wird dann in einer Kombinations-Auswerteschaltung 11 kombiniert. In dieser kann dann in paralleler Form der Vergleich mit den Daten der Masterplatte erfolgen. Die Kombinationsauswerteschaltung 11 arbeitet ebenfalls im Prüftakt und ist dazu wiederum mit der Steuerschaltung 9 verbunden.

Es sei an dieser Stelle bemerkt, daß das Prüfprogramm nicht etwa für alle Prüfbereiche gleich ablaufen muß. So ist es auch möglich, daß in dem einen Prüfbereich erst auf Unterbrechungsfehler und danach auf Isolationsfehler geprüft wird, während die Prüfung in einem anderen Prüfbereich gerade umgekehrt erfolgt.

In Fig. 4 ist eine zu prüfende Ausgangs-Leiterplatte mit zwei jeweils einem Nutzen entsprechenden Prüfbereichen A, B gezeigt, bei der - in Abweichung von der Leiterplatte 1 in Fig. 1 - bereichsübergreifende Leiterbahnen 2' vorgesehen sind. Diese bilden beispielsweise nach der Trennung der beiden Nutzen die Anschlußkontakte für auf die Leiterbahnen 2' an den betreffenden Stellen aufzusteckende Stecker. Wichtig ist hier, daß die in unterschiedlichen Prüfbereichen liegenden Prüfpunkte 3' der bereichsübergreifenden Leiterbahnen 2' während der Parallelprüfung nicht gleichzeitig mit Prüfspannung beaufschlagt werden, da dies zu einem falschen Ergebnis führen könnte. Einer solchen Forderung kann jedoch problemlos dadurch Rechnung getragen werden, daß das Prüfprogramm durch einen entsprechenden Algorithmus gestaltet wird.

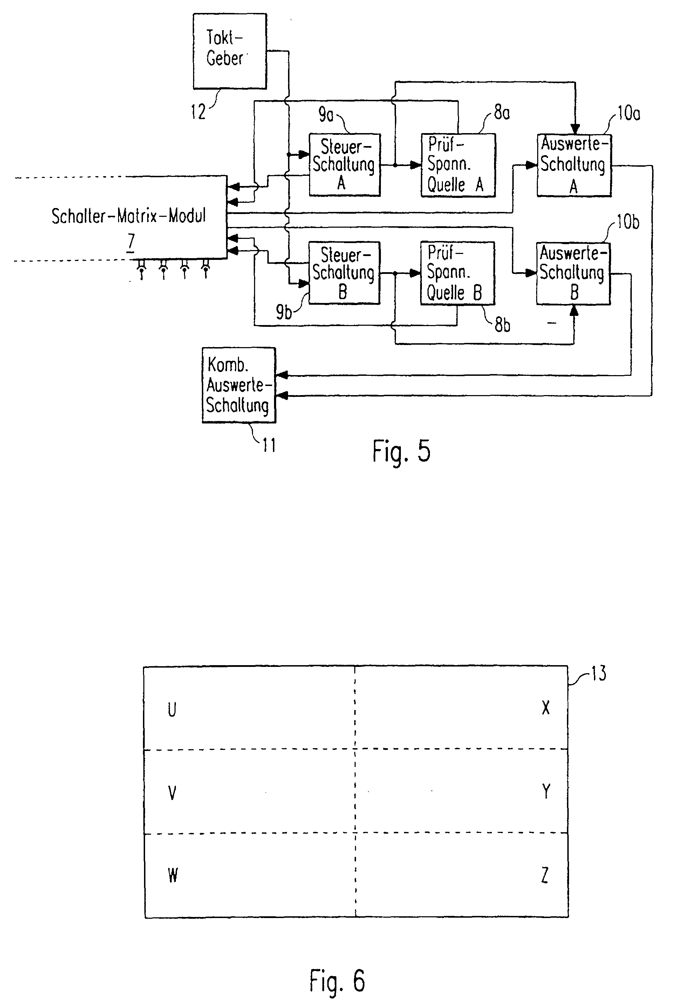

Fig. 5 zeigt wiederum schematisch die gegenüber der bekannten Prüfvorrichtung nach Fig. 2 neuen Teile, um die Ausgangs-Leiterplatte gemäß Fig. 4 nach dem erfindungsgemäßen Verfahren prüfen zu können. Um die beiden Prüfbereiche A und B parallel prüfen zu können ist hier nicht nur die Auswerteschaltung 10 in doppelter Ausführung vorgesehen, sondern es sind auch die Steuerschaltung 9 und die Prüfspannungsquelle 8 in doppelter Ausfertigung vorgesehen.

Zur Prüfung des Prüfbereiches A dient die Steuerschaltung 9a, welche das notwendige Prüfprogramm enthält. Die Steuerschaltung 9a steuert eine Prüfspannungsquelle 8a, welche ihrerseits zu den entsprechenden Takt-Zeitpunkten Prüfspannung an den Schalter-Matrix-Modul 7 liefert. Die Umschaltung der entsprechenden Schalter für den Prüfbereich A in dem Schalter-Matrix-Modul 7 erfolgt durch die Steuerschaltung 9a, welche dazu mit dem Schalter-Matrix-Modul 7 verbunden ist. Das Prüfergebnis für den Prüfbereich A liefert der Schalter-Matrix-Modul 7 durch eine entsprechende Verbindung an die Auswerteschaltung 10a, welche dazu von der Steuerschaltung 9a - ebenfalls durch eine entsprechende Verbindung - getaktet ist.

Der Prüfbereich B wird seinerseits in analoger Weise durch die Steuerschaltung 9b, die Prüfspannungsquelle 8b und die Auswerteschaltung 10b geprüft.

Die beiden Steuerschaltungen 9a und 9b werden ihrerseits durch einen gemeinsamen Taktgeber 12 über entsprechende Verbindungen gesteuert.

Das Auswerteergebnis der Auswerteschaltung 10a für den Prüfbereich A und das Auswerteergebnis der Auswerteschaltung 10b für den Prüfbereich B werden über entsprechende Verbindungen an eine Kombinationsauswerteschaltung 11 geliefert, die dadurch in der Lage ist, Unterbrechungs- und Isolationsfehler auf der gesamten Leiterplatte 1 - unabhängig vom Prüfbereich A oder vom Prüfbereich B - zu registrieren und gegebenenfalls anzuzeigen.

Im folgenden soll anhand der Fig. 6 bis 13 die Anwendung der Erfindungsidee der Parallelprüfung auf eine Prüfvorrichtung mit einem Prüfbereich, der durch mehrere nebeneinander angeordnete Prüfmoduln realisiert ist, wie dies beispielsweise in der EP-B1 0 108 404 offenbart ist, erläutert werden.

In Fig. 6 ist schematisch ein Prüffeld 13 dargestellt, das aus insgesamt sechs in zwei Spalten und drei Reihen nebeneinander angeordneten, autonomen Prüfmoduln U, V, W, X, Y und Z aufgebaut ist, die parallel betrieben werden und ein rechteckiges Prüffeld mit sechs Teilfeldern bilden. Das Schalter-Matrix-Modul 7 der obigen Ausführungsbeispiele wird in diesem Fall durch die sechs Prüfmoduln U-Z ersetzt. Jeder Prüfmodul weist dabei eine eigene Steuerschaltung (nicht gezeigt), eine eigene Prüfspannungsquelle (nicht gezeigt) und eigene Auswerteschaltungen (nicht gezeigt) auf. Ferner ist vorzugsweise ein übergeordnetes Steuerschaltungsteil vorhanden, welches insbesondere für einen gleichzeitigen Prüfvorgang der Prüfmoduln U-Z und eine evt. notwendige gegenseitige Abstimmung der Prüfmoduln U-Z sorgt. Außerdem ist eine übergeordnete kombinierte Auswerteschaltung vorgesehen, die Unterbrechungs- und Isolationsfehler im gesamten Prüfbereich 13 registriert und gegebenenfalls anzeigt.

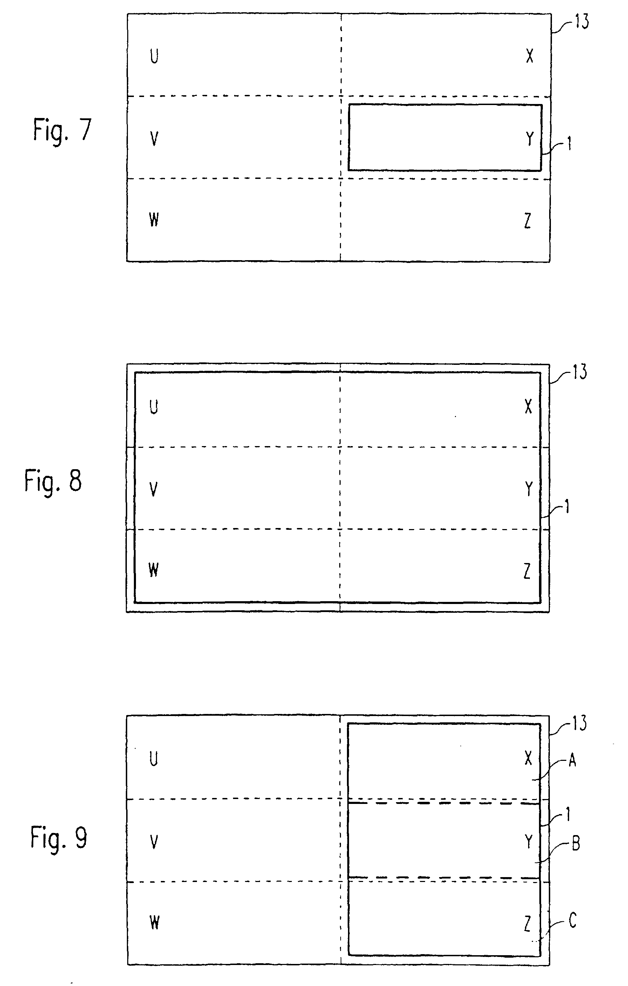

In den Fig. 7 bis 13 sind nachfolgend verschiedene Anwendungsbeispiele eines solchen aus mehreren autonomen Prüfmoduln U-Z zusammengesetzten Prüffeldes 13 für die Parallelprüfung von Leiterplatten dargestellt.

Fig. 7 zeigt zunächst den Fall der Prüfung einer einzelnen Leiterplatte 1, die nur ein Teilfeld Y des Prüffeldes 13 abdeckt. In diesem Anwendungsfall wird gegenüber dem Aufbau des Prüffeldes 13 aus nur einem Modul kein Zeitgewinn erzielt, da die übrigen fünf autonomen Prüfmoduln U-X und Z nicht in den Prüfvorgang eingreifen.

Im Anwendungsbeispiel von Fig. 8 wird auf das Prüffeld 13 eine Leiterplatte 1 gesetzt, die das gesamte Prüffeld 13 abdeckt, wobei die Leiterplatte 1 nicht aus mehreren Nutzen besteht, sondern die Leiterbahnen sich stattdessen über die gesamte Leiterplatte 1 erstrecken. Aufgrund der die Teilfelder U-Z übergreifenden Leiterbahnen auf der Leiterplatte 1 wird gegenüber dem Aufbau des Prüffeldes 13 aus nur einem Modul nur ein relativ geringer Zeitgewinn erzielt.

Soll hingegen, wie in Fig. 9 gezeigt, eine Leiterplatte 1 geprüft werden, die die drei Teilfelder X-Z einer Spalte des Prüffeldes 13 abdeckt und drei den Teilfeldern X, Y, Z lokal zugeordnete Nutzen A, B, C enthält, so ergibt sich gegenüber dem Aufbau des Prüffeldes 13 aus nur einem Modul ein Zeitgewinn gleich einem Faktor 3, weil die drei Nutzen A, B. C der Leiterplatte 1 parallel geprüft werden.

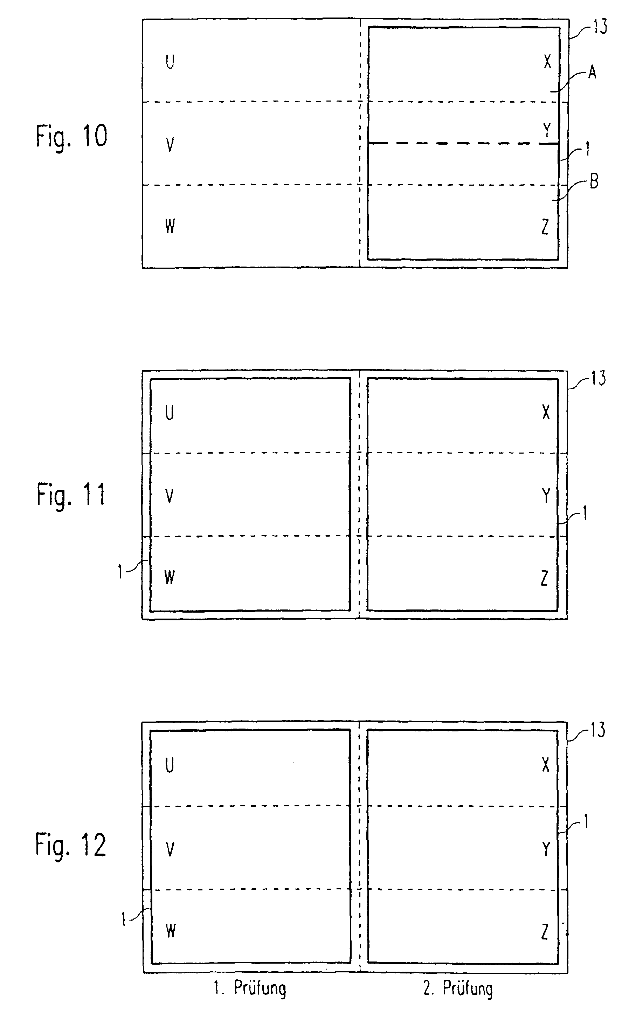

Wenn beispielsweise eine Leiterplatte 1 geprüft werden soll, die sich ebenfalls über die von drei Teilfeldern X-Z gebildete Spalte des Prüffeldes 13 erstreckt und zwei Nutzen A, B enthält, von denen jeder in das mittlere Teilfeld Y übergreift, wie dies in Fig. 10 dargestellt ist, so wird gegenüber dem Aufbau des Prüffeldes 13 aus nur einem Modul ein Zeitgewinn erzielt, der zwar geringer als der vorstehend beschriebene Zeitgewinn von Faktor 3 (Fig. 9), aber größer als Faktor 1 ist, so daß die Parallelprüfung auch in diesem Fall vorteilhaft ist.

Ferner können, wie in Fig. 11 gezeigt, zwei identische, aber voneinander getrennte Leiterplatten 1 parallel geprüft werden, von denen jede eine Spalte des Prüffeldes 13 mit drei Teilfeldern U-W bzw. X-Z abdeckt. Werden - bei Einsatz gleicher Prüfmoduln U-W und X-Z - von jeder Leiterplatte 1 sämtliche Kontaktpunkte 3 bzw. Leiterbahnen 2 geprüft, so ist auch hier ein entsprechender Zeitgewinn erzielbar.

In Fortführung des Anwendungsbeispieles von Fig. 11 können die zwei identischen Leiterplatten 1 auch in zwei aufeinander folgenden Prüfphasen geprüft werden, wie dies in Fig. 12 schematisch dargestellt ist. In der ersten Prüfphase wird von der ersten Spalte U-W des Prüffeldes 13 eine erste Teilzahl der Leiterbahnen 2 (und Kontaktpunkte 3) der ersten Leiterplatte 1 geprüft. In der zweiten, parallel durchgeführten Prüfphase wird von der zweiten Spalte X-Z des Prüffeldes 13 eine zweite Teilzahl der Leiterbahnen 2 (und Kontaktpunkte 3) der zweiten Leiterplatte 1 geprüft, wobei die Leiterbahnen 2 der ersten Teilzahl und die der zweiten Teilzahl verschieden sind und wobei die beiden Teilzahlen der Leiterbahnen 2 sämtliche Leiterbahnen 2 der Leiterplatten 1 umfassen. Anschließend werden die beiden Leiterplatten 1 vertauscht und die erste Leiterplatte 1 durchläuft die zweite Prüfphase der zweiten Spalte X-Z und die zweite Leiterplatte 1 durchläuft die erste Prüfphase der ersten Spalte U-W.

Eine andere Möglichkeit in Anlehung an das Beispiel von Fig. 12 ist die, daß die Leiterplatten 1 nach einer Art Fließband-Verfahren geprüft werden. Dies bedeutet, daß sich an den ersten Testcomputer mit sechs Teilfeldern U-Z ein weiterer Testcomputer mit sechs Teilfeldern U-Z anschließt, so daß die beiden Teilzahlen der Leiterbahnen 1 in verschiedenen Testcomputern geprüft werden. Auch hier kann ein beachtlicher Zeitgewinn erzielt werden.

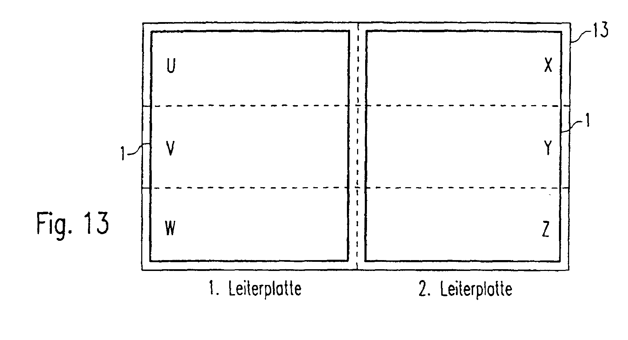

Als weiteres Anwendungsbeispiel kann noch angeführt werden, daß - wie in Fig. 13 gezeigt - gleichzeitig zwei unterschiedliche Leiterplatten 1 in einem Testcomputer geprüft werden, vondenen jede die Größe einer Spalte des Prüffeldes 13 hat. In diesem Fall müssen für die beiden Spalten U-W und X-Z des Prüffeldes 13 unter Umständen unterschiedliche Adapter eingesetzt werden.

Ferner macht es die zunehmende Verdichtung der Kontaktpunkte 3 auf den Leiterplatten 1 immer schwieriger, nebeneinanderliegende Kontaktpunkte 3 gleichzeitig mit Prüfstiften 5 zu kontaktieren. Um dennoch eine Prüfung sehr dicht nebeneinanderliegender Kontaktpunkte 3 vornehmen zu können, ist bereits vorgeschlagen worden, diese mehreren Kontaktpunkte 3 durch eine diese gemeinsam abdeckende und kurzschließende Prüffläche zu kontaktieren. Mindestens einer der gemeinsam abgedeckten Kontaktpunkte 3 sollte dann über eine Leiterbahn 2 von einem Kontaktpunkt 3 der Leiterplatte 1 aus erreichbar sein, der außerhalb der genannten Prüffläche liegt. Auch diese Art der - für sich bekannten-Prüfung trägt in Zusammenhang mit dem Erfindungsgedanken der Paralleprüfung zur Erzielung eines Zeitgewinnes bei.

Die oben beschriebenen Anwendungsbeispiel sind nur eine beispielhafte Auswahl möglicher Anwendungen. Der Fachmann wird ohne weiteres zusätzliche Anwendungsfälle, evt. auch als Kombinationen der oben erläuterten, für die Parallelprüfung mit mehreren autonomen Prüfmoduln auffinden. Die Anwendung ist auch nicht auf ein Prüffeld mit sechs Prüfmoduln beschränkt.

## Patentansprüche

1. Verfahren zum Prüfen einer gedruckten Leiterplatte mit mehreren Grundmustern bzw. Nutzen (A,B,C,D) von Leiterbahnen (2), bei dem die Leiterplatte (1) an bestimmten mit den Leiterbahnen (2) verbundenen Kontaktpunkten (3) mit leitenden Prüfkontakt-Elementen (5) kontaktiert wird, die Prüfkontakt-Elemente (5) oder eine Teilzahl von ihnen nach einem bestimmten Prüfprogramm taktmäßig nacheinander mit einer Prüfspannungsquelle (8) verbunden werden, und während jedes Prüftaktes der über die Prüfkontakt-Elemente (5) fließende Prüfstrom oder ein damit zusammenhängender Parameter gemessen wird,
**dadurch gekennzeichnet,**
**daß** gleiche Grundmuster (A,B,C,D) der Leiterplatte (1) oder mindestens ein Teil von ihnen parallel geprüft werden bzw. wird.

2. Vorrichtung zur Durchführung des Verfahrens nach Anspruch 1, mit einer Vielzahl von zur Kontaktierung der Kontaktpunkte (3) der Leiterplatte (1) bestimmten Prüfkontakt-Elementen (5), einer Prüfspannungsquelle (8), Programmsteuermitteln (9), variablen Verbindungsmitteln, welche von den Programmsteuermitteln so umschaltbar sind, daß die Prüfkontakt-Elemente (5) einzeln oder in Gruppen nach einem bestimmten Prüfprogramm taktweise nacheinander mit der Prüfspannungsquelle (8) verbunden werden, und Auswertemitteln (10), welche den Stromfluß durch die Prüfkontakt-Elemente (5) oder einen damit zusammenhängenden Parameter messen und auswerten,
**dadurch gekennzeichnet,**
**daß** zumindest die Auswertemittel (10) zur Durchführung einer Parallelprüfung von Grundmustern (A,B,C,D) oder eines Teiles von ihnen in mehrfacher Zahl vorgesehen sind.

3. Vorrichtung nach Anspruch 2,
**dadurch gekennzeichnet,**
**daß** außerdem die Prüfspannungsquelle (8) und die Programmsteuermittel (9) in mehrfacher Zahl vorgesehen sind.

4. Vorrichtung zur Durchführung des Verfahrens nach Anspruch 1, mit mehreren nebeneinander angeordneten Prüfmoduln, von denen jeder mit einer Vielzahl von leitenden Prüfkontakt-Elementen (5) verbunden ist, die mit Kontaktpunkten (3) auf der Leiterplatte (1) nach einem bestimmten Prüfprogramm in Verbindung bringbar sind,
**dadurch gekennzeichnet,**
**daß** das Prüfprogramm derart ausgelegt ist, daß die Prüfmoduln die ihnen räumlich zugeordneten Grundmuster (A,B,C,D) der Leiterplatte (1) oder eines Teiles von ihnen gleichzeitig und unabhängig voneinander prüfen.

## Claims

1. A method for testing a printed circuit board with several basic patterns or panels (A, B, C, D) of conductor tracks (2), wherein the circuit board (1) is brought into contact with conducting test-contact elements (5) at certain contact points (3) which are connected to the conductor tracks (2), the test-contact elements (5) or a partial number thereof are connected, in succession in clock-pulsed manner according to a certain test program, to a test-voltage source (8), and during each test clock pulse the test current flowing via the test-contact elements (5) or a parameter related thereto is measured,
**characterised in that**
identical basic patterns (A, B, C, D) of the circuit board (1) or at least some of them are tested in parallel.

2. A device for implementing the method according to Claim 1, with a plurality of test-contact elements (5) intended for contacting the contact points (3) of the circuit board (1), with a test-voltage source (8), with program control means (9), with variable connecting means that are capable of being switched over by the program control means in such a way that the test-contact elements (5) are connected individually or in groups, in succession in clock-pulsed manner according to a certain test program, to the test-voltage source (8) and with evaluating means (10) which measure and evaluate the flow of current through the test-contact elements (5) or a parameter related thereto,
**characterised in that**
at least the evaluating means (10) are provided in multiple number for the purpose of implementing a parallel testing of basic patterns (A, B, C, D) or of some of them.

3. Device according to Claim 2,
**characterised in that**
in addition the test-voltage source (8) and the program control means (9) are provided in multiple number.

4. A device for implementing the method according to Claim 1, with several test modules arranged side by side, each of which is connected to a plurality of conducting test-contact elements (5) that are capable of being brought into contact with contact points (3) on the circuit board (1) in accordance with a certain test program,
**characterised in that**
the test program is designed in such a manner that the test modules test the basic patterns (A, B, C, D) of the circuit board (1) assigned spatially to them, or test some of them, simultaneously and independently of one another.

## Revendications

1. Procédé pour tester une plaquette à circuits imprimés comportant plusieurs motifs de base ou configurations de base (A, B, C, D) de voies conductrices (2), selon lequel la plaquette à circuits imprimés (1) est placée en contact, au niveau de points déterminés de contact (3) reliés aux voies conductrices (2), avec des éléments conducteurs de contact de test (5), les éléments de contact de test (5) ou une partie de ces éléments étant reliés d'une manière cadencée successivement à une source de tension de test (8), selon un programme de test déterminé, et pendant chaque cycle de test, le courant de test, qui circule dans les éléments de contact de test (5) ou un paramètre, qui lui est associé, est mesuré, **caractérisé en ce que** des motifs de base identiques (A, B, C, D) de la plaquette à circuits imprimés (1) ou au moins une partie de ces motifs sont testés en parallèle.

2. Dispositif pour la mise en oeuvre du procédé selon la revendication 1, comportant une multiplicité d'éléments de contact de test (5), qui sont destinés à venir en contact avec les points de contact (3) de la plaquette à circuits imprimés (1), une source de tension de test (8), des moyens de commande par programme (9), des moyens de liaison variables, qui peuvent être commutés par des moyens de commande par programme de telle sorte que les éléments de contact (5) sont reliés successivement de façon cadencée à la source de tension de test (8) individuellement ou par groupes selon un programme de test déterminé, et des moyens d'évaluation (10), qui mesurent et évaluent le flux de courant traversant les éléments de contact de test (5) ou un paramètre qui y est associé, **caractérisé en ce qu'**au moins les moyens d'évaluation (10) pour l'exécution d'un test en parallèle de motifs de base (A, B, C, D) ou d'une partie de ces motifs sont prévus d'une manière multiple.

3. Dispositif selon la revendication 2, **caractérisé en ce qu'**en outre la source de tension de test (8) et les moyens de commande par programme (9) sont prévus d'une manière multiple.

4. Dispositif pour la mise en oeuvre du procédé selon la revendication 1, comportant des modules de test disposés côte-à-côte et dont chacun est relié à une multiplicité d'éléments conducteurs de contact de test (5), qui peuvent être reliés à des points de contact (3) sur la plaquette à circuits imprimés (1) selon un programme déterminé de test, **caractérisé en ce que** le programme de test est conçu de telle sorte que les modules de test testent simultanément et d'une manière indépendante les uns des autres les motifs de base (A, B, C, D), qui leur sont associés spatialement, de la plaquette à circuits imprimés (1) ou une partie de ces motifs.
